# EUROPEAN PATENT APPLICATION

(11) **EP 4 837 951 A1**
(43) Date of publication of application: **11.11.2026**
(21) Application number: 26173848.8
(22) Date of filing: 22.04.2026
(51) Int. Cl.: C11D 7/26, C11D 7/50, G03F 7/42, H10P 50/60, H10P 70/00

(54) **CLEANING SOLUTION, METHOD FOR CLEANING SUBSTRATE, AND METHOD FOR FORMING METAL-CONTAINING FILM**

(30) Priority: 01.05.2025 JP 2025076419
(71) Applicant: SHIN-ETSU CHEMICAL CO., LTD., Tokyo 100-0005 (JP)
(72) Inventor: Iwamori, Shohei, Niigata (JP); Ujiie, Kenta, Joetsu-shi, Niigata, (JP); Kori, Daisuke, Niigata (JP); Nagamachi, Nobuhiro, Niigata, Niigata (JP)
(74) Representative: Schicker, Silvia

(57) **Abstract**

The present invention is a cleaning solution for a composition for forming a metal-containing film, and the cleaning solution includes: (A) an organic acid; (B) a polymer compound having a repeating unit structure having a β-diketone structure; and (C) a solvent. This can provide: a cleaning solution that has excellent detergency, such as removal of a metal-containing film from the peripheral edge of a substrate when a composition for forming a metal-containing film is applied to the substrate, and excellent waste compatibility; a method for cleaning a substrate using the cleaning solution; and a method for forming a metal-containing film using the cleaning method.

## Description

### TECHNICAL FIELD

The present invention relates to:
a cleaning solution, which can be used for fine processing for semiconductor devices, etc., for a composition for forming a metal-containing film; a method for cleaning substrates, and a method for forming a metal-containing film.

### BACKGROUND ART

Along with the high integration and high processing speed of LSIs, the miniaturization of critical dimensions is advancing rapidly. Along with the miniaturization, lithography technology has achieved finer patterning by shortening the light source wavelength and selecting an appropriate resist composition accordingly. The compositions mainly selected for it are a positive photoresist composition used in a single layer. The monolayer positive photoresist composition is a composition in which an exposed part is dissolved to form a pattern, and the remaining resist pattern is used as an etching mask to perform dry etching on a substrate to be processed by allowing the resist composition to have a skeleton having etching resistance to dry etching with chlorine- or fluorine-based gas plasma, and to have a switching mechanism for dissolving an exposed part.

However, when a pattern was miniaturized, i.e., the pattern width was reduced further without changing the thickness of the photoresist film to be used, the photoresist film's resolution performance degraded; in addition, the so-called aspect ratio of the pattern increased excessively during the pattern development of the photoresist film with a developer, causing a problem of pattern collapse. Therefore, the photoresist film has been thinned as the pattern is miniaturized.

On the other hand, a substrate to be processed has been generally processed according to methods by dry-etching the substrate while using a pattern-formed photoresist film as an etching mask. In practice, however, there is no dry etching method capable of achieving an absolute etching selectivity between the photoresist film and the substrate to be processed. Therefore, there was a problem that the photoresist film was also damaged and collapsed during the processing of the substrate, and the resist pattern could not be accurately transferred to the substrate to be processed. Accordingly, higher dry etching resistance has been required in the resist composition as the pattern is miniaturized. On the other hand, however, a resin used for the photoresist composition has been required to have low light absorption at the exposure wavelength in order to improve the resolution. For this reason, the resin has shifted to a novolak resin, polyhydroxystyrene, and a resin having an aliphatic polycyclic skeleton, as the exposure light shifted to i-line, KrF, and ArF, which have shorter wavelengths. However, these shifts have actually accelerated the etching rate under dry etching conditions for processing the substrate, and recent photoresist compositions having high resolution are prone to having lower etching resistance.

As a result, the substrate to be processed has to be dry-etched using a thinner photoresist film having lower etching resistance. Accordingly, it has become an urgent necessity to ensure a composition used in the processing and the process.

A multilayer resist method is one of the solutions for the above problems. This method is as follows: a resist middle layer film having a different etching selectivity from a photoresist film (i.e., a resist upper layer film) is placed between a resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed using a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even when using a resist composition with which it is difficult to form a pattern having a sufficient film thickness for directly processing the substrate to be processed, or when using a resist composition that has insufficient dry etching resistance for processing the substrate. Then, when the pattern is transferred by dry etching with oxygen or hydrogen gas plasma, the pattern can be obtained in the organic film (resist underlayer film) containing a novolak resin or the like, which has a sufficient dry etching resistance for processing the substrate. As to the resist underlayer film as described above, many materials have already been publicly known, including those disclosed in Patent Document 1, for example.

On the other hand, in recent years, due to the accelerated miniaturization of DRAM memory, there has been a growing need for further improvement in dry etching resistance, as well as for developing a resist underlayer film having excellent filling properties and excellent planarizing properties. As a coating-type organic underlayer film material excellent in filling and planarizing properties, for example, the material disclosed in Patent Document 2 has been reported. However, given the application of these compositions to cutting-edge fields in the advanced generation, there is concern about dry etching resistance, and the application limit of the conventional coating-type organic underlayer film compositions is thus approaching.

To solve the problems, it is under consideration to develop a resist underlayer film using a material containing a metal element. By baking, ligands coordinated to a metal atom in a composition for forming a metal-containing film thermally decompose; hydrolysis and condensation progress; a metal oxide is formed; and a resist underlayer film excellent in dry etching resistance can be formed. Patent Document 3 reports that a material containing a Ti compound exhibits excellent dry etching resistance to CHF₃/CF₄-based gas and CO₂/N₂-based gas.

When a composition for forming a metal-containing film is used for a resist underlayer film, there is a risk of a metal compound's bonding to the surface of a substrate, such as a silicon wafer, when the composition for forming a metal-containing film is applied to the substrate, thereby causing a residue. To remove such a residue, there is a proposal to use a cleaning solution containing an organic solvent and a carboxylic acid (Patent Document 4). In addition, Patent Document 5 proposes a cleaning solution containing solvent, an organic acid, and an additive that functions as a chelating agent.

On the other hand, given practicality, when the above-mentioned multilayer resist method is performed using a single apparatus, wastewater streams from multiple processes are often discharged through the same pipe, and waste compatibility is desired for the cleaning solution to prevent unintended events, such as metal precipitation in the pipes due to interference among multiple wastewater streams.

### CITATION LIST

### PATENT LITERATURE

Patent Document 1: JP2004-205685A
Patent Document 2: JP2017-119671A
Patent Document 3: JP2016-532739A
Patent Document 4: JP2019-532489A
Patent Document 5: JP2020-173361A

### SUMMARY OF INVENTION

### TECHNICAL PROBLEM

The present invention has been made to solve the above-described problem. An object of the present invention is to provide: a cleaning solution that has excellent detergency, such as removal of a metal-containing film from the peripheral edge of a substrate when a composition for forming a metal-containing film is applied to the substrate and waste compatibility and excellent waste compatibility; a method for cleaning a substrate using the cleaning solution; and a method for forming a metal-containing film using the cleaning method.

### SOLUTION TO PROBLEM

To achieve the object, the present invention provides a cleaning solution for a composition for forming a metal-containing film, the cleaning solution comprising:
(A) an organic acid;
(B) a polymer compound having a repeating unit structure having a β-diketone structure; and
(C) a solvent.

Such a cleaning solution can exhibit a two-coordinate chelate effect due to the β-diketone structure in the component (B), and a strong four-coordinate or higher chelate effect by being a polymer having a β-diketone structure in its repeating unit. Therefore, it is possible to improve the cleaning solution's metal removal performance.

Furthermore, in the component (B), the repeating unit structure having a β-diketone structure is preferably represented by the following general formula (B-1), 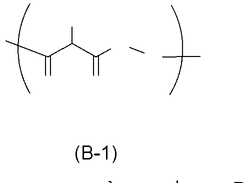 wherein, R₁ represents a hydrogen atom, a substituted or unsubstituted alkyl group having 1 to 30 carbon atoms, a substituted or unsubstituted branched or cyclic alkyl group having 3 to 30 carbon atoms, a substituted or unsubstituted aliphatic unsaturated organic group having 2 to 30 carbon atoms and having one or more double or triple bonds, a substituted or unsubstituted alkoxy group having 1 to 30 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom; and X represents a divalent organic group represented by the following general formula (B-1a),

*¹- - -*²

wherein, "W" represents a divalent organic group, "*¹" represents an attachment point to an oxygen atom, and "*²" represents an attachment point to a carbonyl carbon atom of the β-diketone structure.

A cleaning solution containing a polymer compound (B) having such a repeating unit structure can further improve metal removal performance and waste compatibility.

W in the general formula (B-1a) preferably represents any one of a substituted or unsubstituted alkylene group having 1 to 30 carbon atoms, a substituted or unsubstituted branched or cyclic alkylene group having 3 to 30 carbon atoms, a substituted or unsubstituted divalent aliphatic unsaturated organic group having 2 to 30 carbon atoms and having one or more double or triple bonds, a substituted or unsubstituted heteroalkylene group having 1 to 30 carbon atoms, and a substituted or unsubstituted divalent aryl group having 6 to 30 carbon atoms.

A cleaning solution containing a polymer compound (B) having such a repeating unit structure can still further improve metal removal performance and waste compatibility.

X in the general formula (B-1) preferably has a structure represented by the following formula (B-2a), 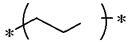 wherein m₁ represents the average number of repeating units, which represents 1 to 10, and "*" represents an attachment point.

By selecting an appropriate structure and an appropriate chain length range for X, it is possible to still further improve metal removal performance and waste compatibility.

The weight-average molecular weight Mw of the polymer having the repeating unit structure represented by the general formula (B-1) is preferably in the range of 1,000≤Mw≤30,000, in terms of polystyrene, as determined by gel permeation chromatography.

When the molecular weight of the polymer is 1,000 or higher, the polymer has many β-diketone structures in the molecule, which can further improve metal removal performance, suppress volatilization in the cleaning solution, and enable formation of an economical cleaning solution composition. When the molecular weight is 30,000 or lower, the risk of precipitation after metal coordination can be avoided, and waste compatibility can be improved without degrading compatibility with other wastewater streams.

The solvent (c) preferably comprises at least one dissolving agent selected from the group consisting of a ketone dissolving agent and an ester dissolving agent.

Using such a solvent can improve the cleaning solution's stability over time.

The organic acid (A) contained in the cleaning solution is preferably a carboxylic acid.

When the cleaning solution contains a carboxylic acid as an organic acid, the metal removal performance can be further improved.

The compound (B) is preferably contained in an amount of 0.1 to 10 mass% relative to the total mass of the cleaning solution.

By setting the contained amount of the compound (B) in the cleaning solution within the above range, it is possible to further improve the metal removal performance, the cleaning solution's stability over time, and the waste compatibility.

The organic acid (A) is preferably contained in an amount of 0.5 to 80 mass% relative to the total mass of the cleaning solution.

By setting the contained amount of the organic acid in the cleaning solution within the above range, it is possible to further improve the metal removal performance, the cleaning solution's stability over time, and the waste compatibility.

Furthermore, the present invention provides a method for cleaning a substrate comprising the steps of: applying a composition for forming a metal-containing film directly or indirectly to a substrate; and cleaning the substrate with the inventive cleaning solution.

Such a method for cleaning a substrate can reduce metal residues on a substrate, which are generated when a composition for forming a metal-containing film is applied.

Furthermore, the present invention provides a method for forming a metal-containing film comprising the steps of: by using a composition for forming a metal-containing film comprising a metal compound (M) and a dissolving agent (D), applying the composition for forming a metal-containing film directly or indirectly to a substrate; and cleaning a peripheral edge of the substrate using the inventive cleaning solution.

Such a method for forming a metal-containing film can reduce metal residues on a substrate, which are generated when the composition for forming a metal-containing film is applied, and therefore can be suitably used in a process for forming a metal-containing film using the composition for forming a metal-containing film.

### ADVANTAGEOUS EFFECTS OF INVENTION

As described above, the inventive cleaning solution includes an organic acid (A), a polymer compound (B) having a repeating unit structure including a β-diketone structure, and a solvent (C). Therefore, when a composition for forming a metal-containing film is applied to a substrate, it is possible to provide a cleaning solution that exhibits excellent in detergency, such as removing the metal-containing film from the peripheral edge of a substrate, and waste compatibility. Furthermore, in methods for cleaning a substrate and methods for formation using a metal-containing film that use this cleaning solution, it is possible to use a cleaning solution excellent in detergency and excellent waste compatibility, thereby suppressing problems, such as contamination to an apparatus, and enabling the efficient formation of a desired resist underlayer film without reducing productivity. These cleaning solutions can be used suitably in manufacturing semiconductor devices that are expected to become increasingly miniaturized hereafter.

### BRIEF DESCRIPTION OF DRAWINGS

FIG. 1 is a flow diagram of an example in which a metal-containing film is formed on a substrate and the film on the peripheral edge is removed with the inventive cleaning solution;
FIG. 2 is a flow diagram of an example in which a metal-containing film is formed on a substrate and the metal-containing film is removed with the inventive cleaning solution; and
FIG. 3 is a flow diagram of an example for the inventive method for forming a metal-containing film.

### DESCRIPTION OF EMBODIMENTS

In a process of manufacturing a semiconductor device or the like, one of treatments performed in the process of forming a metal-containing film pattern is a peripheral coating film-removal (Edge Bead Removal: EBR) treatment in which a solvent is supplied to a substrate having a metal-containing film formed on the surface and the unnecessary film on the coating-film periphery is removed in a ring shape. This EBR treatment is performed by discharging a cleaning solution from a solvent nozzle locally onto the periphery of a rotating substrate.

In the EBR treatment of a metal-containing film, there have been demands for: a cleaning solution excellent in metal detergency, such as removal of a metal-containing film on the periphery of a substrate when a composition for forming a metal-containing film is applied to the substrate, and excellent in waste compatibility when mixed with another waste liquid; a method for cleaning a semiconductor substrate by using the cleaning solution; and a method for forming a metal-containing film by using the cleaning method.

Conventional techniques use cleaning solutions containing organic solvents and carboxylic acids to remove metal-containing films, but there is room for improvement in metal removal performance and waste compatibility.

As a result of their diligent study of the above problems, the inventors found that the above problems could be solved by a cleaning solution containing (B) a polymer compound having a repeating unit structure having a β-diketone structure, and have completed the present invention.

Specifically, the present invention is a cleaning solution for a composition for forming a metal-containing film, the cleaning solution comprising:
(A) an organic acid;
(B) a polymer compound having a repeating unit structure having a β-diketone structure; and
(C) a solvent.

Hereinafter, the present invention will be described in detail, but the present invention is not limited thereto.

### <Cleaning Solution>

The inventive cleaning solution is a cleaning solution for a composition for forming a metal-containing film and includes an organic acid (A), a compound (B) having 2 or more β-diketone structures per molecule, and a solvent (C). The inventive cleaning solution is used to clean up a substrate coated with a composition for forming a metal-containing film.

### [(A) Organic Acid]

The inventive cleaning solution contains an organic acid (A). Adding an organic acid to the cleaning solution improves the removal performance of a metal-containing film formed on a substrate.

Examples of the organic acids include carboxylic acids, sulfonic acids, sulfinic acids, organic phosphinic acids, organic phosphonic acids, phenols, enols, thiols, acid imides, oximes, and sulfonamides.

The organic acid is preferably a sulfonic acid or a carboxylic acid, more preferably a carboxylic acid. Specific examples of sulfonic acids include methanesulfonic acid, ethanesulfonic acid, N-(2-acetamido)-2-aminoethanesulfonic acid, morpholinoethanesulfonic acid, amidinothiopropanesulfonic acid, 2-acrylamido-2-methylpropanesulfonic acid, N,N-bis(2-hydroxyethyl)-2-aminoethanesulfonic acid, 2-hydroxy-3-morpholinopropanesulfonic acid, camphorsulfonic acid, 3-(cyclohexylamino)-2-hydroxypropane-1-sulfonic acid, 2-[4-(2-hydroxyethyl)-1-piperazinyl]ethanesulfonic acid, benzenesulfonic acid, pyridinesulfonic acid, aminobenzenesulfonic acid, hydroxybenzenesulfonic acid, hydroxypyridine sulfonic acid, xylenesulfonic acid, pyridylethanesulfonic acid, toluidinesulfonic acid, diaminobenzenesulfonic acid, hydrazinobenzenesulfonic acid, aminophenolsulfonic acid, chlorobenzenesulfonic acid, aminodimethylbenzenesulfonic acid, aminomethoxybenzenesulfonic acid, chloroaniline sulfonic acid, naphthalene sulfonic acid, sulfoisoquinoline, 3-cyclohexylaminopropane sulfonic acid, aminochlorotoluene sulfonic acid, aminonaphthalene sulfonic acid, aminochlorophenol sulfonic acid, diaminotrimethylbenzene sulfonic acid, aminonaphthol sulfonic acid, dichloroaniline sulfonic acid, hydroquinoline sulfonic acid, dimethylaminosulfonic acid, ethoxyquinoline sulfonic acid, trichlorobenzene sulfonic acid, iodobenzene sulfonic acid, anilinonaphthalene sulfonic acid, nonafluoro-1-butanesulfonic acid, hydroxymethoxybenzophenone sulfonic acid, lumogallion, hydroxyiodoquinolinesulfonic acid, calmagite, naphthalenedisulfonic acid, dimethylsulfonazo III, vinyl sulfonic acid, aminomethanesulfonic acid, hydroxylamine-O-sulfonic acid, aminoethanesulfonic acid, aminopropanesulfonic acid, chlorosulfonic acid, and trifluoromethanesulfonic acid.

Examples of the carboxylic acids include: carboxylic acids, such as formic acid, acetic acid, propionic acid, butanoic acid (butyric acid), isobutanoic acid (isobutyric acid), pentanoic acid, hexanoic acid, 2-ethylhexanoic acid, cyclohexanecarboxylic acid, cyclohexylacetic acid, 1-adamantanecarboxylic acid, benzoic acid, and phenylacetic acid, each having a carboxyl group and at least one selected from an aliphatic saturated hydrocarbon group and aromatic hydrocarbon group,; fluorine atom-containing monocarboxylic acids, such as difluoroacetic acid, trifluoroacetic acid, pentafluoropropanoic acid, heptafluorobutanoic acid, fluorophenylacetic acid, and difluorobenzoic acid; monocarboxylic acids containing a group containing a heteroatom other than a fluorine atom in a moiety other than a carboxy group, such as 10-hydroxydecanoic acid, 5-oxohexanoic acid, 3-methoxycyclohexanecarboxylic acid, camphorcarboxylic acid, dinitrobenzoic acid, nitrophenylacetic acid, lactic acid, glycolic acid, glyceric acid, salicylic acid, anisic acid, gallic acid, and furancarboxylic acid; unsaturated monocarboxylic acids, such as acrylic acid, methacrylic acid, crotonic acid, isocrotonic acid, 3-butenoic acid, angelic acid, tiglic acid, 4-pentenoic acid, cinnamic acid, sorbic acid, propiolic acid, and 2-butynoic acid; polycarboxylic acids, such as oxalic acid, malonic acid, succinic acid, glutaric acid, adipic acid, dodecanedicarboxylic acid, propanetricarboxylic acid, butanetetracarboxylic acid, cyclohexanehexacarboxylic acid, 1,4-naphthalenedicarboxylic acid, phthalic acid, isophthalic acid, terephthalic acid, trimellitic acid, pyromellitic acid, and 1,2,3,4-cyclobutanetetracarboxylic acid, each having a plurality of carboxyl groups and at least one selected from a single bond, an aliphatic saturated hydrocarbon group, and an aromatic hydrocarbon group; partially esterified products of the polycarboxylic acids; fluorine atom-containing polycarboxylic acids, such as difluoromalonic acid, tetrafluorophthalic acid, and hexafluoroglutaric acid; polycarboxylic acids containing a heteroatom other than a fluorine atom in a moiety other than a carboxy group, such as tartaric acid, citric acid, malic acid, tartronic acid, diglycolic acid, and iminodiacetic acid; and unsaturated polycarboxylic acids, such as maleic acid, fumaric acid, and aconitic acid.

From the viewpoints of detergency and waste compatibility, the organic acid is further preferably at least one selected from the group consisting of formic acid, acetic acid, citric acid, oxalic acid, 2-ethylhexanoic acid, dodecanoic acid, ascorbic acid, tartaric acid, glucuronic acid, acrylic acid, methacrylic acid, crotonic acid, isocrotonic acid, 3-butenoic acid, and methanesulfonic acid.

The lower limit of the proportion of the organic acid contained relative to all the components contained in the cleaning solution is preferably 0.5 mass%, more preferably 1 mass%, further preferably 2.0 mass%, and particularly preferably 3 mass%. The upper limit of the contained proportion is preferably 80 mass%, more preferably 70 mass%, further preferably 65 mass%, and particularly preferably 60 mass%. When the proportion of the organic acid contained is in the above ranges, detergency and waste compatibility can be further enhanced.

### [(B) Polymer Compound]

The inventive cleaning solution contains a polymer compound (B) having a repeating unit structure having a β-diketone structure. The polymer compound (B) exerts a two-coordinate chelate effect due to the β-diketone structure in the component (B), and a strong four-coordinate or higher chelate effect by being a polymer having a β-diketone structure in its repeating unit, thereby improving the removal performance of the cleaning solution.

The polymer compound (B) preferably contains a polymer compound having a repeating unit structure represented by the following general formula (B-1).

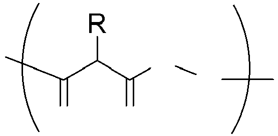

In the formula, R₁ represents a hydrogen atom, a substituted or unsubstituted alkyl group having 1 to 30 carbon atoms, a substituted or unsubstituted branched or cyclic alkyl group having 3 to 30 carbon atoms, a substituted or unsubstituted aliphatic unsaturated organic group having 2 to 30 carbon atoms and having one or more double or triple bonds, a substituted or unsubstituted alkoxy group having 1 to 30 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom; and X represents a divalent organic group represented by the following general formula (B-1a).

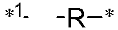

In the above formula, W represents a divalent organic group, "*¹" represents an attachment point to an oxygen atom, and "*²" represents an attachment point to a carbonyl carbon atom of the β-diketone structure.

In the general formula (B-1), R₁ is preferably a hydrogen atom, a substituted or unsubstituted alkyl group having 1 to 30 carbon atoms, a substituted or unsubstituted branched or cyclic alkyl group having 3 to 30 carbon atoms, a substituted or unsubstituted aliphatic unsaturated organic group having 2 to 30 carbon atoms and having one or more double or triple bonds, a substituted or unsubstituted alkoxy group having 1 to 30 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom. Specific examples are exemplified by the following structures. However, from the viewpoints of material availability, metal removal performance, and waste compatibility, a hydrogen atom, a substituted or unsubstituted saturated alkyl group having 1 to 10 carbon atoms, or a substituted or unsubstituted heteroalkyl group having 1 to 10 carbon atoms is more preferable.

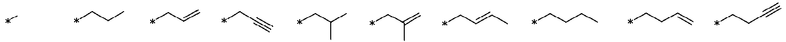

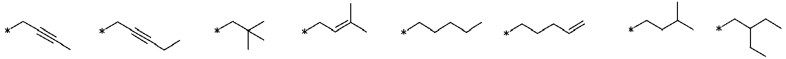

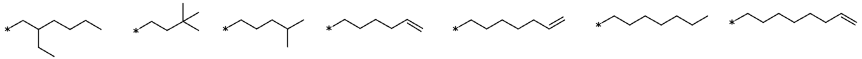

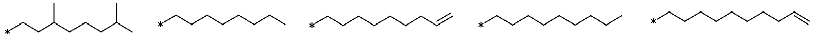

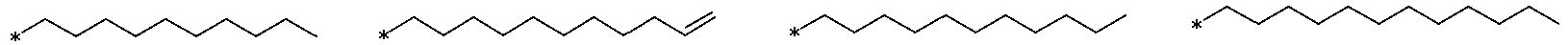

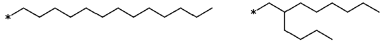

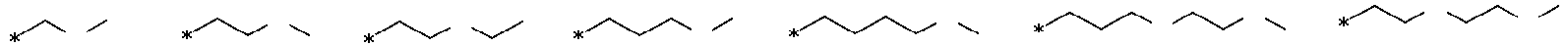

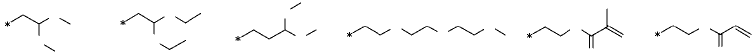

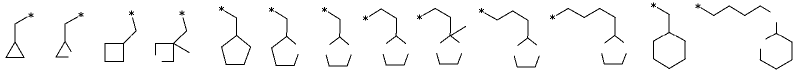

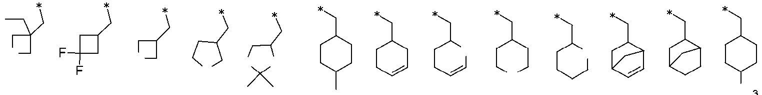

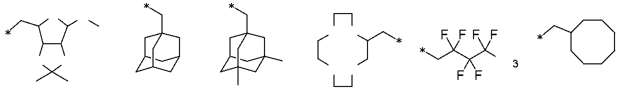

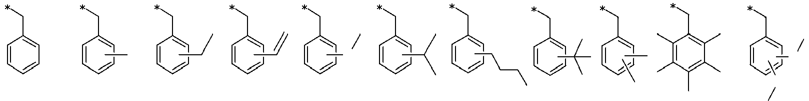

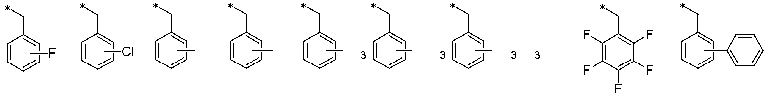

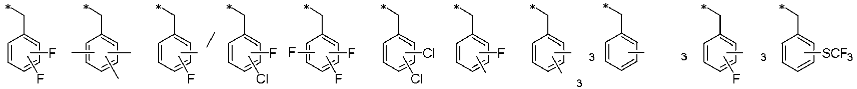

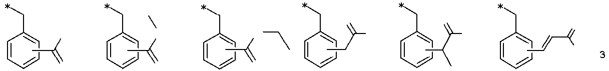

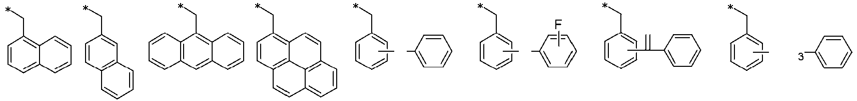

In the above general formula (B-1a), "W" is preferably a saturated or unsaturated divalent organic group having 1 to 30 carbon atoms, and is preferably any one of a substituted or unsubstituted alkylene group having 1 to 30 carbon atoms, a substituted or unsubstituted branched or cyclic alkylene group having 3 to 30 carbon atoms, a substituted or unsubstituted divalent aliphatic unsaturated organic group having 2 to 30 carbon atoms and having one or more double or triple bonds, a substituted or unsubstituted heteroalkylene group having 1 to 30 carbon atoms, and a substituted or unsubstituted divalent aryl group having 6 to 30 carbon atoms. From the viewpoint of the affinity for the cleaning solutions and the detergency of the composition for forming a metal-containing organic film, "W" is more preferably an alkylene group having 1 to 20 carbon atoms or a heteroalkylene group having 1 to 20 carbon atoms.

Such a polymer compound has a β-diketone structure in the repeating unit of the main chain structure, which allows the main chain to have multiple chelate structures. Furthermore, since it is not a monomolecular compound, volatilization during cleaning can be suppressed, making it possible to reduce the adding amount thereof to the cleaning solution. Furthermore, as described above, not only stripping properties due to the chelating effect with the metal-containing film-forming composition, but also the crystallinity and solvent solubility of the polymer compound can be controlled by appropriately selecting the structure of W, which constitutes the main chain, according to the required performance. When used as a component of a cleaning solution, it is excellent not only in stripping properties but also in effect of suppressing precipitates when mixed with various cleaning solutions, resist materials, etc., making it possible to form a cleaning solution composition with excellent stability over time as a cleaning solution.

Specific examples of "W" include, but are not limited to, the following.

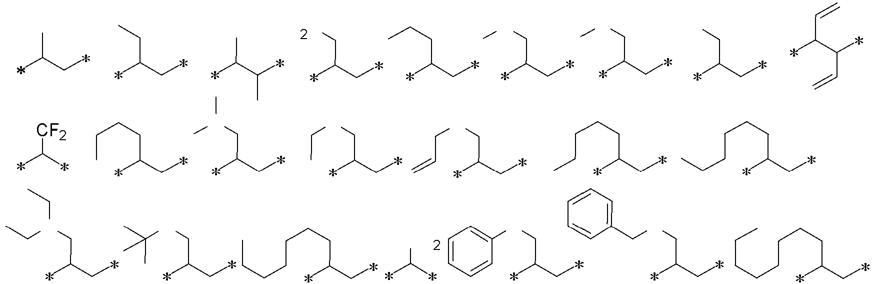

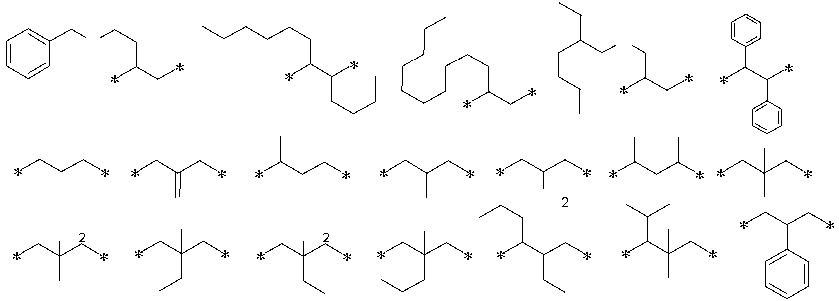

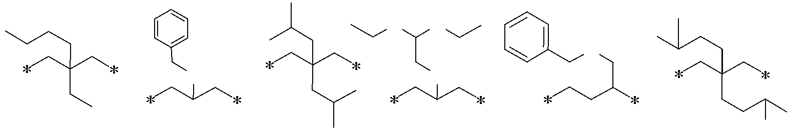

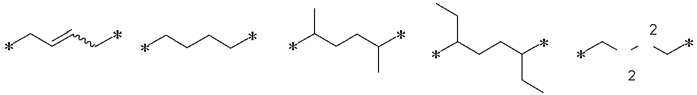

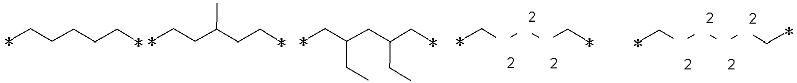

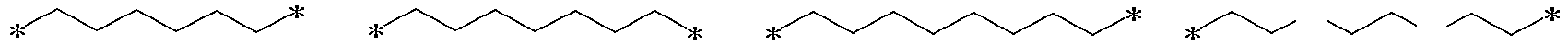

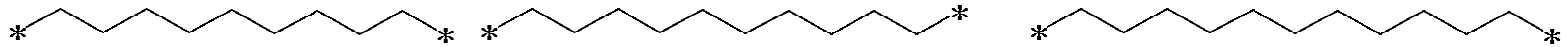

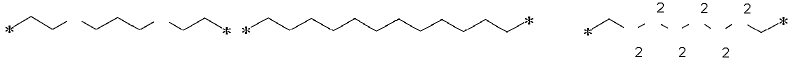

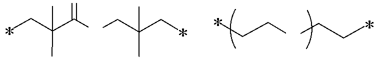

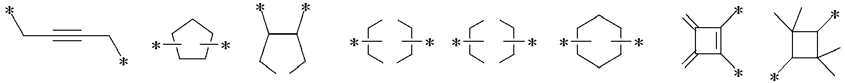

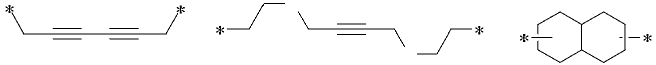

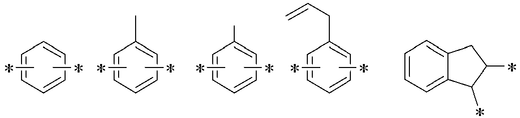

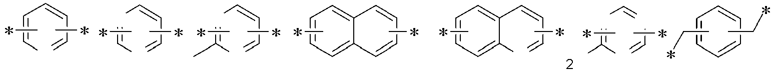

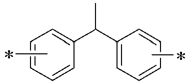

In the above formulae, "m" represents 0 to 14, and "*" represents an attachment point to the oxygen atom.

A polymer compound having such a structure can provide a cleaning solution that is excellent in detergency for removing metal-containing films and waste compatibility.

Also in the above general formula (B-1), X has more preferably a structure represented by the following formula (B-2a).

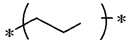

In the formula, m₁ represents the average number of repeating units, which represents 1 to 10, and "*" represents an attachment point.

By adjusting the main chain structure represented by X of the inventive polymer compound to an appropriate structure with a chain length within an appropriate range, it is possible to construct a cleaning solution that exhibits excellent detergency, such as removing metal-containing films, and excellent waste compatibility.

The weight-average molecular weight Mw of the polymer having the repeating unit structure represented by the general formula (B-1) is preferably in the range of 1,000≤Mw≤30,000, more preferably 2,000≤Mw≤20,000, as determined by gel permeation chromatography in terms of polystyrene.

The column configuration of the above gel permeation chromatography was TSKguedcolumn + TSKgel G4000HXL + TSKgel G3000HXL + TSKgel G2000HXL + TSKgel G2000HXL. The pump column temperature was 40°C, the eluent was tetrahydrofuran, and the detector was a differential refractive index detector.

When the molecular weight is 1,000 or higher, the compound contains many β-diketone structures in a molecule, which can further improve metal removal performance and suppress volatilization in the cleaning solution, making it possible to produce an economical cleaning solution composition. When the molecular weight is 30,000 or less, the risk of precipitation after metal coordination can be avoided, and waste compatibility can be improved without degrading compatibility with other wastewater.

The compound (B) content is preferably 0.1 to 10 mass% relative to the total mass of the cleaning solution.

### [(C) Solvent]

The solvent (C) contained in the inventive cleaning solution includes, but is not limited to, water and organic solvents.

Examples of the organic solvent include glycol ethers and esters thereof, such as propylene glycol methyl ether (PGME), propylene glycol ethyl ether (PGEE), propylene glycol propyl ether (PGPE), propylene glycol butyl ether (PGBE), propylene glycol methyl ethyl acetate (PGMEA), and ethylene glycol methyl ether; alcohols, such as ethanol, propanol, isopropyl alcohol, isobutyl alcohol, hexanol, ethylene glycol, and propylene glycol; cyclic esters, such as γ-butyrolactone; esters, such as n-butyl acetate and ethyl acetate; ketones, such as 2-heptanone, cyclopentanone, and cyclohexanone; liquid cyclic carbonates, such as propylene carbonate and butylene carbonate; and cyclic sulfones, such as sulfolane.

Among these, glycol ethers, glycol ether esters, or ketones are preferable as the solvent, and propylene glycol methyl ether (PGME), propylene glycol ethyl ether (PGEE), propylene glycol monopropyl ether (PGPE), propylene glycol methyl ethyl acetate (PGMEA), 2-heptanone, cyclopentanone, and cyclohexanone are preferable. In addition, hydroxy-free organic solvents are preferable. It is further preferable that the solvent contains at least one dissolving agent selected from the group consisting of ketone-based dissolving agents and ester-based dissolving agents. Specifically, glycol ether esters or linear ketones are more preferable, and propylene glycol methyl ethyl acetate (PGMEA) and 2-heptanone are more preferable.

By using a hydroxyl-free organic solvent, it is possible to suppress an esterification reaction with an organic acid contained in the cleaning solution during storage.

In this embodiment, one kind of the solvent may be used, or two or more kinds thereof may be used as a mixed solvent. In the cleaning solution according to this embodiment, the lower limit of the solvent content is preferably 20 mass% or more, more preferably 30 mass% or more, and further preferably 35 mass% or more, relative to the total mass of the cleaning solution. The upper limit of the solvent content is preferably 99 mass% or less, more preferably 98 mass% or less, and further preferably 95 mass% or less, relative to the total mass of the cleaning solution.

### [Other Components]

The cleaning solution according to this embodiment may contain other components in addition to the above components, depending on the purpose of the present invention. Examples of the other components include inorganic hydrofluoric acids, tetraalkylammonium compounds, and surfactants. Examples of inorganic hydrofluoric acids include hexafluorosilicic acid, hexafluorophosphoric acid, and fluoroboric acid. Examples of the tetraalkylammonium compounds include tetramethylammonium fluoride, tetrabutylammonium fluoride, and tetrabutylammonium fluorosilicate. Examples of surfactants include those disclosed in paragraphs [0142] to [0147] of JP2009-269953A. Regarding each additive, one kind may be used, or two or more kinds may be used in combination. In the cleaning solution according to this embodiment, the contained amount of the additives is preferably 0 to 10 mass% relative to the total mass of the cleaning solution.

### <Method for Preparing a Cleaning Solution>

The inventive cleaning solution can be prepared by mixing an organic acid (A), a polymer compound (B) having a repeating unit structure having a β-diketone structure, a solvent (C), and, if necessary, other organic acids and optional components, in predetermined proportions, and then filtering the resulting mixture through a filter, with a pore size of 0.5 µm or less, or the like. A smaller filter pore size is preferable from the perspective of removing foreign matter and metal impurities present in the materials of the cleaning solution. The filter's pore size is preferably 0.1 µm or less, more preferably 0.05 µm or less. The filter substrate, i.e., the material that constitutes the filter, is preferably one from which metals do not leach. Examples of such materials include nylon, polyethylene, polypropylene, polystyrene, and fluororesin. One kind of these materials may be used, two or more kinds thereof may be used in combination, or these materials may be homogenized to form a so-called polymer alloy structure.

### <Method for Cleaning Substrate>

The inventive cleaning solution can be used for removing a metal-containing film on the periphery of a substrate when the composition for forming a metal-containing film was applied to the substrate.

The inventive method for cleaning a substrate includes the steps of: applying a composition for forming a metal-containing film directly or indirectly to a substrate; and cleaning the substrate with the cleaning solution described above.

When the composition for forming a metal-containing film is a material for a resist underlayer film, after the above cleaning step, it is preferable to include further the steps of: forming a photoresist film directly or indirectly on the metal-containing film formed in the above coating step (a resist-pattern forming step); subjecting the photoresist film to exposure; forming a photoresist pattern by development; and transferring the resist pattern directly or indirectly to the metal-containing film by etching while using the resist pattern as a mask.

When the composition for forming a metal-containing film is a material for a photoresist film, it is preferable to include the steps of: subjecting the photoresist film to exposure; forming a photoresist pattern by development; and transferring the resist pattern directly or indirectly to the substrate by etching while using the resist pattern as a mask.

The periphery of the substrate means, for example, the peripheral portion of the substrate that is within a length of 3.0 cm from the peripheral edge of the substrate towards the center of the substrate. The length from the peripheral edge of the substrate towards the center of the substrate can be 2.0 cm, 1.0 cm, 0.5 cm, or 0.2 cm.

When the composition for forming a metal-containing film is a material for a resist underlayer film, the method for manufacturing a semiconductor substrate may further include, as necessary, before the resist pattern forming step, a step (organic-resist underlayer-film forming step) of forming an organic resist underlayer film directly or indirectly on the substrate having the metal-containing film formed in the above coating step.

When the composition for forming a metal-containing film is a material for a silicon-containing film, the method for manufacturing a semiconductor substrate may further include, as necessary, before the resist-pattern forming step, a step (silicon-containing film forming step) of forming a silicon-containing film directly or indirectly on the substrate having the metal-containing film formed in the above coating step.

In the following, descriptions will be given regarding: the composition for forming a metal-containing film and cleaning solution, which are used in the method for manufacturing a semiconductor substrate; and each of the steps when the step of forming organic underlayer film and silicon-containing film forming step, being optional steps, are included.

### <Composition for Forming Metal-Containing Film>

Compositions for forming a metal-containing film to which the inventive cleaning solution is applicable are not particularly limited as long as a metal compound (M) and a dissolving agent (D) are contained. The composition for forming a metal-containing film may also contain other optional components depending on the purpose. The composition for forming a metal-containing film is preferably a material usable as a photoresist film or a resist underlayer film.

The metal compound (M) is preferably a compound having a metal atom and an oxygen atom. Examples of the metal atoms constituting the metal compound (M) include metal atoms of Groups 3 to 16 of the periodic table (excluding a silicon atom). The metal compound (M) may contain one kind of metal atoms, or two or more kinds thereof.

As the metal atoms constituting the metal compound (M) :
examples of Group 3 metals include scandium, yttrium, lanthanum, and cerium;
examples of Group 4 metals include titanium, zirconium, and hafnium;
examples of Group 5 metals include vanadium, niobium, and tantalum;
examples of Group 6 metals include chromium, molybdenum, and tungsten;
examples of Group 7 metals include manganese and rhenium;
examples of Group 8 metals include iron, ruthenium, and osmium;
examples of Group 9 metals include cobalt, rhodium, and iridium;
examples of Group 10 metals include nickel, palladium, and platinum;
examples of Group 11 metals include copper, silver, and gold;
examples of Group 12 metals include zinc, cadmium, and mercury;
examples of Group 13 metals include aluminum, gallium, and indium;
examples of Group 14 metals include germanium, tin, and lead;
examples of Group 15 metals include antimony and bismuth; and
examples of Group 16 metals include tellurium.

As the metal atom constituting the metal compound (M), metal atoms of Group 3 to Group 16 are preferable, metal atoms of Group 4 to Group 14 are more preferable, metal atoms of Group 4, Group 5, and Group 14 are further preferable, and metal atoms of Group 4 are particularly preferable. Specifically, preferable are titanium, chromium, manganese, iron, cobalt, nickel, copper, zinc, zirconium, molybdenum, indium, tin, hafnium, tantalum, tungsten, bismuth, and combinations thereof.

As a component (hereinafter, also referred to as a compound "X"), other than metal atoms, constituting the metal compound (M), it is preferable that the compound contains one or more of hydrolysable groups or ligands, wherein the ligand is derived from a compound containing an organic acid (hereinafter, also referred to as "an organic acid (a)"), a hydroxy acid ester, β-diketones, a β-diketo esters, amine, amide, an olefin, hydrocarbon having a π bond, or diphosphines. Here, "organic acid" indicates an organic compound that exhibits acidity, and "organic compound" indicates a compound having at least one carbon atom. Forms in which the organic acid (a) can be contained also include organic acid anions obtained by removing a hydrogen ion from the organic acid (a).

Examples of the hydrolysable group include halogen atoms, alkoxy groups, and acyloxy groups.

Examples of the halogen atoms include a fluorine atom, a chlorine atom, a bromine atom, and an iodine atom.

As the alkoxy groups, alkoxy groups having 1 to 10 carbon atoms are preferable, and examples include a methoxy group, an ethoxy group, an n-propoxy group, an i-propoxy group, a butoxy group, and an octyloxy group.

Examples of the acyloxy groups include an acetoxy group, an ethylyloxy group, a propionyloxy group, a butyryloxy group, a t-butyryloxy group, a t-amylyloxy group, an n-hexanecarbonyloxy group, and an n-octanecarbonyloxy group.

As the hydrolysable group, alkoxy groups and acyloxy groups are preferable, and an n-propoxy group, an i-propoxy group, a butoxy group, and an octyloxy group are more preferable.

Examples of the organic acid (a) include carboxylic acid, sulfonic acid, sulfinic acid, organic phosphinic acid, organic phosphonic acid, phenols, enol, thiol, acid imides, oxime, and sulfonamide.

Examples of the carboxylic acid include: monocarboxylic acids, such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids, such as oxalic acid, malonic acid, maleic acid, methylmalonic acid, fumaric acid, adipic acid, sebacic acid, phthalic acid, and tartaric acid; and carboxylic acids having three or more carboxy groups, such as citric acid.

Examples of the sulfonic acid include benzenesulfonic acid and p-toluenesulfonic acid.

Examples of the sulfinic acid include benzenesulfinic acid and p-toluenesulfinic acid.

Examples of the organic phosphinic acid include diethylphosphinic acid, methylphenylphosphinic acid, and diphenylphosphinic acid.

Examples of the organic phosphonic acid include methylphosphonic acid, ethylphosphonic acid, t-butylphosphonic acid, cyclohexylphosphonic acid, and phenylphosphonic acid.

Examples of the phenols include: monohydric phenols, such as phenol, cresol, 2,6-xylenol, and naphthol; dihydric phenols, such as catechol, resorcinol, hydroquinone, and 1,2-naphthalenediol; and phenols having a valency of three or more, such as pyrogallol and 2,3,6-naphthalenetriol.

Examples of the enol include 2-hydroxy-3-methyl-2-butene and 3-hydroxy-4-methyl-3-hexene.

Examples of the thiol include mercaptoethanol and mercaptopropanol.

Examples of the acid imides include: carboxylic acid imides, such as maleimide and succinimide; and sulfonic imides, such as di(trifluoromethanesulfonic acid)imide and di(pentafluoroethanesulfonic acid)imide.

Examples of the oxime include: aldoximes, such as benzaldoxime and salicylaldoxime; and ketoximes, such as diethylketoxime, methylethylketoxime, and cyclohexanone oxime.

Examples of the sulfonamide include methylsulfonamide, ethylsulfonamide, benzenesulfonamide, and toluenesulfonamide.

As the organic acid (a), carboxylic acids having 1 to 10 carbon atoms are preferable.

Examples of the hydroxy acid esters include glycolic acid esters, lactic acid esters, 2-hydroxycyclohexane-1-carboxylic acid esters, and salicylic acid esters.

Examples of the β-diketones include 2,4-pentanedione, 3-methyl-2,4-pentanedione, and 3-ethyl-2,4-pentanedione.

Examples of the β-keto esters include acetoacetic acid esters, α-alkyl-substituted acetoacetic acid esters, β-ketopentanoic acid esters, benzoylacetic acid esters, and 1,3-acetonedicarboxylic acid esters.

Examples of the amine compounds include pyridine, trimethylamine, piperidine, diethanolamine, and triethanolamine.

Examples of the compounds containing amide include compounds containing unsubstituted amide (NH₂), methylamide (NHMe), dimethylamide (NMe₂), diethylamide (NEt₂), and dipropylamide (NPr₂).

Examples of the compounds containing olefin include: chain olefins, such as ethylene and propylene; and cyclic olefins, such as cyclopentene, cyclohexene, and norbornene.

Examples of the hydrocarbons having a π bond include: chain dienes, such as butadiene and isoprene; cyclic dienes, such as cyclopentadiene, methylcyclopentadiene, pentamethylcyclopentadiene, cyclohexadiene, and norbornadiene; and aromatic hydrocarbons, such as benzene, toluene, xylene, hexamethylbenzene, naphthalene, and indene.

Examples of diphosphines include 1,1-bis(diphenylphosphino)methane, 1,2-bis(diphenylphosphino)ethane, 1,3-bis(diphenylphosphino)propane, 2,2' - bis(diphenylphosphino)-1,1' -binaphthyl, and 1,1' - bis(diphenylphosphino)ferrocene.

Examples of the metal compound (M) include compounds represented by the following formula (M-1). By using such a metal compound (M-1), a stable metal compound (M) can be formed, and dry etching resistance can be enhanced.

LₐM(=O)_{b}X_{c} (M-1)

In the formula, "M" represents any of titanium, chromium, manganese, iron, cobalt, nickel, copper, zinc, zirconium, molybdenum, indium, tin, hafnium, tantalum, tungsten, and bismuth. "L" represents a monodentate ligand or polydentate ligand having 1 to 30 carbon atoms, and "X" represents a hydrolysable group selected from a halogen atom, an alkoxy group, a carboxylate group, an acyloxy group, and -NR^{a}R^{b}. R^{a} and R^{b} each independently represent a hydrogen atom or a monovalent organic group having 1 to 20 carbon atoms. a+c is 1 to 6, "a" represents an integer of 0 to 4, "b" represents an integer of 0 to 2, and "c" represents an integer of 0 to 6.

Examples of the hydrolysable group "X" of the formula (M-1) include halogen atoms, alkoxy groups, carboxylate groups, acyloxy groups, and -NR^{a}R^{b}. R^{a} and R^{b} preferably each independently represent a hydrogen atom or a monovalent organic group having 1 to 20 carbon atoms.

Examples of the halogen atoms include a fluorine atom, a chlorine atom, a bromine atom, and an iodine atom.

Examples of the alkoxy groups include a methoxy group, an ethoxy group, an n-propoxy group, an i-propoxy group, an n-butoxy group, and a t-butoxy group.

Examples of the carboxylate groups include: monocarboxylic acids, such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids, such as oxalic acid, malonic acid, maleic acid, methylmalonic acid, fumaric acid, adipic acid, sebacic acid, phthalic acid, and tartaric acid; and ligands derived from carboxylic acids having three or more carboxy groups, such as citric acid.

Examples of the acyloxy groups include an acetoxy group, an ethylyloxy group, a propionyloxy group, a butyryloxy group, a t-butyryloxy group, a t-amylyloxy group, an n-hexanecarbonyloxy group, and an n-octanecarbonyloxy group.

Examples of the -NR^{a}R^{b} include an unsubstituted amino group, a methylamino group, a dimethylamino group, a diethylamino group, and a dipropylamino group.

As the hydrolysable group X, an alkoxy group is preferable, and an i-propoxy group, an n-butoxy group, or a t-butoxy group is more preferable.

### (Monodentate Ligand)

Examples of the monodentate ligand include a hydroxo ligand, amido ligands, amine ligands, and olefin ligands.

Examples of the amido ligands include an unsubstituted amido ligand (NH₂), a methylamido ligand (NHMe), a dimethylamido ligand (NMe₂), a diethylamido ligand (NEt₂), and a dipropylamido ligand (NPr₂).

Examples of the amine ligands include pyridine, a trimethylamine ligand, and a piperidine ligand.

Examples of the olefin ligands include: chain olefins, such as ethylene and propylene; cyclic olefins, such as cyclopentene, cyclohexene, and norbornene.

### (Polydentate Ligand)

Examples of the polydentate ligand include ligands derived from hydroxy acid esters, ligands derived from β-diketones, ligands derived from β-keto esters, hydrocarbons having a π bond, and diphosphines.

Examples of the hydroxy acid esters include glycolic acid esters, lactic acid esters, 2-hydroxycyclohexane-1-carboxylic acid esters, and salicylic acid esters.

Examples of the β-diketones include acetoacetic acid esters, α-alkyl-substituted acetoacetic acid esters, β-ketopentanoic acid esters, benzoylacetic acid esters, and 1,3-acetonedicarboxylic acid esters.

Examples of the β-diketo esters include malonic acid diesters, α-alkyl-substituted malonic acid diesters, α-cycloalkyl-substituted malonic acid diesters, and α-aryl-substituted malonic acid diesters.

Examples of the hydrocarbons having a π bond include: chain dienes, such as butadiene and isoprene; cyclic dienes, such as cyclopentadiene, methylcyclopentadiene, pentamethylcyclopentadiene, cyclohexadiene, and norbornadiene; and aromatic hydrocarbons, such as benzene, toluene, xylene, hexamethylbenzene, naphthalene, and indene.

Examples of the diphosphines include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, and 1,1'-bis(diphenylphosphino)ferrocene.

The monodentate ligand and the polydentate ligand may contain a crosslinkable group. As the crosslinkable group, the ligand preferably contains any of a vinyl group, an allyl group, an allyloxy group, an ethynyl group, a propargyl group, a propargyloxy group, an epoxy group, and an oxetanyl group. When a metal compound having such a ligand is contained, it is possible to form a compound for metal-containing film excellent in thermosetting property.

Furthermore, the metal compound (M) may be, for example, a compound containing an inorganic anion, such as an anion of an oxoacid (phosphate ion, sulfate ion, chromate ion, tungstate ion (WO₄²⁻), molybdate ion (MoO₄²⁻), etc.) or a polyacid anion, in which multiple oxoacids are condensed, or a mixture thereof.

The polyacid anion may be an isopolyacid anion (Mm'On')^{c-} or a heteropolyacid anion (X₁'Mm'On')^{c-}. In the ionic formulae, "M" represents a polyatom, X represents a heteroatom, "m'" represents the composition ratio of polyatoms, "n'" represents the composition ratio of oxygen atoms, and "l'" represents the composition ratio of heteroatoms. "c" represents the valence. Examples of the polyatom "M" include Mo, W, Ti, and Nb. Examples of the heteroatom X include Si, P, As, S, Fe, and Co. A counter cation, such as Na⁺ and H⁺, may be partly contained.

In particular, in view of excellent heat resistance, an anion of an inorganic acid containing at least one of tungsten (W) and molybdenum (Mo) is preferable.

Examples of the polyacids containing at least one of tungsten (W) and molybdenum (Mo) include: isopolyacids, such as tungstate ion [W₁₀O₃₂]⁴⁻ and molybdate ion [Mo₆O₁₉]²⁻; and heteropolyacids, such as phosphotungstate ion [PW₁₂O₄₀]³⁻, [P₂W₁₈O₆₂]⁶⁻, silicotungstate ion [SiW₁₂O₄₀]⁴⁻, phosphomolybdate ion [PMo₁₂O₄₀]³⁻, silicomolybdate ion [SiMo₁₂O₄₀]⁴⁻, phosphotungstomolybdate ion [PW₁₂₋ₓMoₓO₄₀]³⁻ ("x" represents an integer of 1 to 11), [P₂W_{18-y}Mo_{y}O₆₂]⁶⁻ ("y" represents an integer of 1 to 17), silicotungstomolybdate ion [SiW₁₂₋ₓMoₓO₄₀]⁴⁻ ("x" represents an integer of 1 to 11). As the polyacid containing at least one of the tungsten (W) and the molybdenum (Mo), heteropolyacid is preferable among the above, and furthermore, a heteropolyacid containing phosphorus (P) is more preferable from the viewpoint of heat resistance and from the viewpoint of the availability of raw materials.

Furthermore, any of phosphotungstomolybdate ion [PW₁₀Mo₂O₄₀]³⁻, [PW₁₁Mo₁O₄₀]³⁻, and phosphotungstate ion [PW₁₂O₄₀]³⁻ is further preferable from the viewpoint of heat resistance.

The metal compound (M) may be a hydrolysis product of a metal compound containing a hydrolysable group, a hydrolysis condensate of a metal compound containing a hydrolysable group, or a combination thereof. Here, a "hydrolysis condensation reaction" indicates a reaction in which a hydrolysable group contained in a metal compound hydrolyzes and is converted to a hydroxy group (-OH), and two hydroxy groups (-OH) obtained undergo dehydration condensation to form an ether bond (-O-).

It is also possible to use a compound obtained by subjecting the above-described compounds to a ligand substitution reaction with a material that may become a monodentate ligand or a polydentate ligand. In addition, it is also possible to use a hydrolysis condensation reaction product of a metal-containing compound having a hydrolysable group or a compound obtained by allowing a hydrolysis condensation reaction product of a metal-containing compound having a hydrolysable group to react with a material that may become a monodentate ligand or a polydentate ligand.

Specific examples of the metal compound (M) include the following, but are not limited thereto.

Examples of the compounds containing titanium include diisopropoxybis(2,4-pentanedionate)titanium(IV), tetra-n-butoxytitanium(IV), tetra-n-propoxytitanium(IV), titanium tetraisopropoxide(IV), tri-n-butoxymonostearatetitanium(IV), tetrakis(2-ethylhexyl) orthotitanate, dihydroxybis(hydrogen lactato)titanium(IV), titanium(IV)butoxide oligomer, aminopropyltrimethoxytitanium(IV), triethoxymono(2,4-pentanedionate)titanium(IV), tri-n-propoxymono(2,4-pentanedionate)titanium(IV), triisopropoxymono(2,4-pentanedionate)titanium, and di-n-butoxybis(2,4-pentanedionate)titanium(IV).

Examples of the compounds containing chromium include chromium(III)tris(2-ethylhexanoate), tris(2,4-pentanedionato)chromium(III), bis(2,2,6,6-tetramethyl-3,5-heptanedionato)chromium(II), tris(trifluoro-2,4-pentanedionato)chromium(III), chromium(III) pyridine-2-carboxylate, chromium(III) chloride, chromium(II) chloride, and chromium(II) cyclohexanecarboxylate.

Examples of the compounds containing nickel include nickel(II) acetate, nickel chloride, nickel(II) 2-ethylhexanoate, bis(2,4-pentanedionato)nickel(II) hydrate, bis(hexafluoroacetylacetonato)nickel(II), nickel(II) 2-amino-5-methylbenzenesulfonate, nickel(II) trifluoromethanesulfonate, bis(2,2,6,6-tetramethyl-3,5-heptanedionato)nickel(II), and nickel(II) propionate.

Examples of the compounds containing manganese include tris(2,2,6,6-tetramethyl-3,5-heptanedionato)manganese(III).

Examples of the compounds containing iron include tris(2,2,6,6-tetramethyl-3,5-heptanedionato)iron(III), iron(II) oxocyclohexanecarboxylate, and iron chloride.

Examples of the compounds containing cobalt include dichloro[ethylenebis(diphenylphosphine)]cobalt, cobalt(II) bromide, cobalt(II) acetate, tris(1,3-diphenyl-1,3-propanedione)cobalt(III), and cobalt(II) cyclopentylacetate.

Examples of the compounds containing copper include copper(II) acetate, monobutyl phthalate copper(II), copper(II) acetylacetonate, copper(I) heptanoate, and copper(II) 2-ethylhexanoate.

Examples of the compounds containing zinc include zinc diisopropoxide, zinc(II) acetate, zinc(II) chloride, and zinc(II) 4-vinylbenzoate.

Examples of the compounds containing zirconium include dibutoxybis(ethylacetoacetate)zirconium(IV), din-butoxybis (2, 4-pentanedionate) zirconium (IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono(2,4-pentanedionate)zirconium(IV), tri-n-propoxymono (2, 4-pentanedionate) zirconium (IV), triisopropoxymono(2,4-pentanedionate) zirconium(IV), tri(3-methacryloxypropyl)methoxyzirconium(IV), tri(3-acryloxypropyl)methoxyzirconium(IV), zirconium(IV) acetate, diacetoxyzirconium(IV) oxide, zirconium(II)bis(2-ethylhexanoate), tetra(2-ethylhexanoic acid)zirconium(IV), bis(2-ethylhexanoic acid)oxozirconium(IV), zirconium nitrate, zirconium(IV) chloride, and zirconium carboxyethyl acrylate (IV).

Examples of the compounds containing molybdenum include pentaethoxymolybdenum(V), molybdenum(VI)hexaethoxide, molybdenum(V) isopropoxide, molybdenum(II) acetate dimer, molybdenum(IV) oxide bis(acetylacetonate), molybdenum(VI) oxide bis(2,2,6,6-tetramethyl-3,5-heptanedionate), molybdenum 2-ethylhexanoate, molybdenum(V) chloride, and molybdenum(III) chloride.

Examples of compounds containing indium include tris(1,3-diphenyl-1,3-propanedione)indium(III), indium(III) ethylbutyrate, indium(III) acetate, and indium(III)triisopropoxide.

Examples of the compounds containing tin include tin(II) acetate, tin(IV) acetate, tin(II)acetylacetonate, tin(IV) tert-butoxide, tin tetra-n-butoxide, tin tetraisopropoxide, tin(II) 4-fluorobenzeneacetate, and tin(II) 2-ethylhexanoate.

Examples of the compounds containing hafnium include diisopropoxybis(2,4-pentanedionate)hafnium(IV), tetrabutoxyhafnium(IV), tetraisopropoxyhafnium(IV), tetraethoxyhafnium(IV), dichlorobis(cyclopentadienyl)hafnium(IV), hafnium(IV) chloride, tetrakis(dimethylamido)hafnium(IV), tetrakis(ethylmethylamido)hafnium(IV), hafnium carboxyethyl acrylate, bis(cyclopentadienyl)hafnium(IV) dichloride, hafnium(IV) trifluoromethanesulfonate hydrate, and hafnium carboxyethyl acrylate (IV).

Examples of the compounds containing tantalum include tantalum(V) methoxide, tantalum(V) ethoxide, tetrabutoxytantalum(IV), pentabutoxytantalum(V), pentaethoxytantalum(V), tantalum(V) chloride, pentakis(dimethylamino)tantalum(V), tris(diethylamido)(tert-butylimido)tantalum(V), and bis(2-ethylhexanoic acid) tantalum(II).

Examples of the compounds containing tungsten include tungsten(VI) ethoxide, tetrabutoxy tungsten(IV), pentabutoxy tungsten(V), pentamethoxy tungsten(V), hexabutoxy tungsten(VI), hexaethoxy tungsten(VI), and dichlorobis(cyclopentadienyl)tungsten(IV).

Examples of the compounds containing bismuth include bismuth(III)-n-butoxide, bismuth(III) tri-t-amiloxide, triethoxybismuth(III), bismuth(III) tris(β-diketonate), bismuth(III) neodecanoate, tris(2-naphthol)bismuth(III), bismuth(III) fluoride, bismuth(III) bromide, bismuth(III) iodide, bismuth(III) oxychloride, bismuth(III) acetate, bismuth(III) subsalicylate, bismuth(III) 2-ethylhexanoate, and bismuth(III) trifluoromethanesulfonate.

### [(D) Dissolving Agent]

The dissolving agent (D) usable in the inventive composition for forming a metal-containing film is not particularly limited as long as the dissolving agent can dissolve the above-described metal compound (M), the other additives contained, etc.

Specific examples of the dissolving agent (D) include propylene glycol monomethyl ether acetate, propylene glycol monomethyl ether, propylene glycol monoethyl ether, propylene glycol monopropyl ether, 2-heptanone, cyclopentanone, cyclohexanone, and γ-butyrolactone. Alternatively, a mixture containing one or more thereof is preferably used.

Examples of other dissolving agents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, methyl isobutyl ketone, and cyclopentyl methyl ether.

The dissolving agent (D) is preferably contained in a range of 200 to 10,000 parts by mass, more preferably 250 to 5,000 parts by mass relative to 100 parts by mass of the metal compound (M).

### <Other Additives>

At least one of a crosslinking agent (E), an acid generator (F), and a surfactant (G) may be contained in accordance with the purpose of the composition for forming a metal-containing film.

In the following, components that may be contained in the composition for forming a metal-containing film other than the metal compound (M) and the dissolving agent (D) will be described.

### [(E) Crosslinking Agent]

When the composition for forming a metal-containing film is used for a resist underlayer film, a crosslinking agent (E) may also be added to increase curability and further suppress intermixing with a resist upper layer film. The crosslinking agent is not particularly limited, and various types of publicly known crosslinking agents can be used widely. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agents (E) can be used, or two or more kinds thereof can be used in combination. When the crosslinking agent (E) is added, the contained amount is preferably 5 to 50 parts by mass, more preferably 10 to 40 parts by mass relative to 100 parts by mass of the metal compound (M). When the contained amount is 5 parts by mass or more, sufficient curability can be exhibited, and intermixing with a resist upper layer film can be suppressed. On the other hand, when the contained amount is 50 parts by mass or less, there is no risk of degradation in dry etching resistance caused by the decreased proportion of the metal compound (M) in the composition.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agents include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-based crosslinking agents include compounds represented by the following general formula (10).

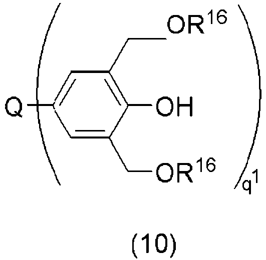

In the formula, "Q" represents a single bond or a q¹-valent hydrocarbon group having 1 to 20 carbon atoms. R¹⁶ represents a hydrogen atom or an alkyl group having 1 to 20 carbon atoms. q¹ represents an integer of 1 to 5.

In the general formula (10), "Q" represents a single bond or a hydrocarbon group having a valency of q¹ and having 1 to 20 carbon atoms. q¹ represents an integer of 1 to 5, more preferably 2 or 3. Specific examples of "Q" include groups each of which is obtained by removing q¹ hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

From the viewpoints of enhancing the curability and film thickness uniformity, the compound represented by the general formula (10) is preferably hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene.

### [(F) Acid Generator]

The composition for forming a metal-containing film in the present invention may contain an acid generator (F), and for example, may contain a compound (photo-acid generator) that generates an acid in response to actinic light or radiation. The photo-acid generator can be any photo-acid generator as long as the compound generates an acid upon high-energy beam irradiation. Suitable photo-acid generators include sulfonium salt, iodonium salt, sulfonyldiazomethane, N-sulfonyloxyimide, and oxime-O-sulfonate type acid generators. Specific examples of the acid generator include those disclosed in paragraphs [0122] to [0142] of JP2008-111103A, JP2009-080474A, and JP2015-026064A.

One kind of the acid generator (F) may be used, or two or more kinds thereof may be used in combination. When the acid generator is contained, the contained amount is preferably 0.05 to 50 parts by mass, more preferably 0.1 to 10 parts by mass based on 100 parts by mass of the metal compound (M).

### [(G) Surfactant]

A surfactant (G) may be contained in the composition for forming a metal-containing film in order to improve coating property in spin-coating. Examples of the surfactant include those disclosed in [0142] to [0147] of JP2009-269953A. When the surfactant (G) is contained, the contained amount is preferably 0.01 to 10 parts by mass, more preferably 0.05 to 5 parts by mass based on 100 parts by mass of the metal compound (M).

### [Coating Step]

In the coating step, a substrate is coated directly or indirectly with the composition for forming a metal-containing film. Methods for applying the composition for forming a metal-containing film are not particularly limited, and for example, can be performed by an appropriate method, such as spin coating, flow casting, and roll coating. Thus, a coating film is formed, and by the volatilization of the dissolving agent (D) and so forth, a metal-containing film is formed.

The substrate to be coated with the composition for forming a metal-containing film is not particularly limited, and include substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

The lower limit of the average thickness of the formed metal-containing film is preferably 3 nm, more preferably 5 nm, and further preferably 10 nm. The upper limit of the average thickness is preferably 500 nm, more preferably 200 nm, and further preferably 60 nm. It should be understood that the method for measuring the average thickness is as described in the Examples.

The method for manufacturing the substrate preferably further includes a step of heating the coating film formed in the coating step (hereinafter, also referred to as a "heating step"). By heating the coating film, the formation of the metal-containing film is promoted. More specifically, the volatilization of the dissolving agent (D) and so forth is promoted by the heating of the coating film.

The heating of the coating film is usually performed in the atmosphere, but can also be performed under a nitrogen atmosphere. The lower limit of the temperature at the heating is preferably 150°C, more preferably 200°C. The upper limit of the temperature is preferably 600°C, more preferably 500°C. The lower limit of the time at the heating is preferably 15 seconds, more preferably 30 seconds. The upper limit of the time is preferably 1,200 seconds, more preferably 600 seconds.

### [Cleaning Step]

In this step, the periphery of the substrate is cleaned with a cleaning solution. As the cleaning solution, the inventive cleaning solution described above can be used suitably.

The cleaning method is not particularly limited, and it is possible to adopt a known cleaning method for a semiconductor manufacturing process, for example, edge bead removal, back rinse, etc. In the present invention, the step of cleaning the substrate having the formed metal-containing film preferably includes applying the inventive cleaning solution along the periphery of the substrate and removing the edge bead on the substrate (hereinafter, referred to as "edge rinse" in some cases).

Typically, firstly, a substrate having a metal-containing film formed is rotated at a predetermined rate. Next, while discharging a cleaning solution from a cleaning solution discharge nozzle, the cleaning solution discharge nozzle travels at a predetermined speed from the peripheral edge of the rotating substrate towards the center of the substrate. The traveling is stopped when the cleaning solution discharge nozzle has travelled a predetermined distance, and the cleaning solution is further discharged for a predetermined time. After that, the discharge of the cleaning solution from the cleaning solution discharge nozzle is stopped, and by performing drying as necessary, the cleaning is completed. The rotational rate of the substrate, the discharge amount of the cleaning solution per unit time, the travel speed and travel distance of the cleaning solution discharge nozzle, the length of the discharge time of the cleaning solution after the traveling of the cleaning solution discharge nozzle is stopped, etc., may be set appropriately depending on the substrate size, the number, types, and thickness of formed films, the area to be cleaned, etc.

The number of times of the edge rinse is not particularly limited, and may be 1 to 20 times. Furthermore, during edge rinsing, two or more kinds of cleaning solution can be applied.

In the edge rinse, the cleaning solution is preferably dropped in an amount of 0.05 to 50 ml, more preferably 0.075 to 40 ml, and further preferably 0.1 to 30 ml.

After applying the composition for forming a metal-containing film to the substrate, the cleaning step can be performed after performing or not performing the heating step. After the coating step, in a case where the cleaning step is performed without going through the heating step, it is preferable to perform the heating step after the cleaning step.

The metal-containing film formed in the above-described step is preferably either a photoresist film or a resist underlayer film.

In addition, the inventive cleaning solution can also be used for reworking the metal-containing film on a substrate to reuse the substrate. The cleaning solution discharge nozzle travels to the center of the substrate, and the cleaning solution is discharged onto the rotating substrate for a predetermined time. After that, the discharging of the cleaning solution from the cleaning solution discharge nozzle is stopped, and by performing drying as necessary, the cleaning is completed. The rotational rate of the substrate, the discharge amount of the cleaning solution per unit time, the discharge position of the cleaning solution, etc., can be set appropriately depending on the substrate size, the number, types, and thickness of formed films, the cleaned area, etc.

To evaluate the metal-removability by virtue of the edge rinse, residual metal on the substrate can be inspected. A suitable approach commercially available for evaluating trace metal generally includes inductively coupled plasma mass spectrometry (ICP-MS). To evaluate the surface of the substrate, vapor phase decomposition-inductively coupled plasma mass spectrometry (VPD-ICP-MS) can be employed. Using this technology, the residual metal can be determined per unit area of the wafer surface along the edge.

In the inventive method for cleaning a substrate, when the metal-containing film is Zr-based, the amount of residual Zr is preferably 100×10¹⁰ atoms/cm² or less, more preferably 50×10¹⁰ atoms/cm² or less, further preferably 10×10¹⁰ atoms/cm² or less, and particularly preferably 5×10¹⁰ atoms/cm² or less.

### [Method for Forming a Metal-Containing Film]

The method for forming a metal-containing film of the present invention including the steps of: by using a composition for forming a metal-containing film including a metal compound (M) and a dissolving agent (D), applying the composition for forming a metal-containing film directly or indirectly to a substrate; and cleaning a peripheral edge of the substrate using the inventive cleaning solution described above.

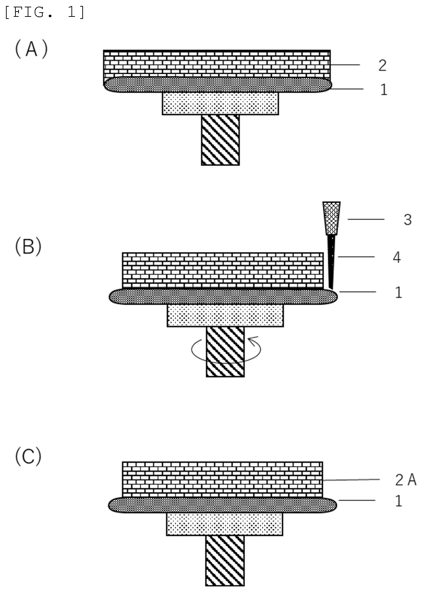

Next, embodiments of the present invention will be described with reference to FIGs. 1 to 3. However, the cleaning method of the present invention is not limited thereto, and can also be carried out using methods other than these cleaning methods.

First, as a first embodiment of the present invention, a method for removing a film on the outer peripheral edge using the inventive cleaning solution will be described with reference to FIG. 1.

In a first embodiment of the present invention (FIG. 1), (A) a substrate to be processed (1) on which a metal-containing film (2) (A) has been formed is placed in a spin coater. Next, (B) the spin coater is rotated at a predetermined rate, and the film at the outer periphery is removed while a cleaning solution (4) of the present invention from a cleaning solution dispensing nozzle (3) disposed at the outer periphery is dispensed. Then, the resultant is subjected to drying as necessary, yielding a metal-containing film from which the film at the outer periphery has been removed (2A), as shown in (C).

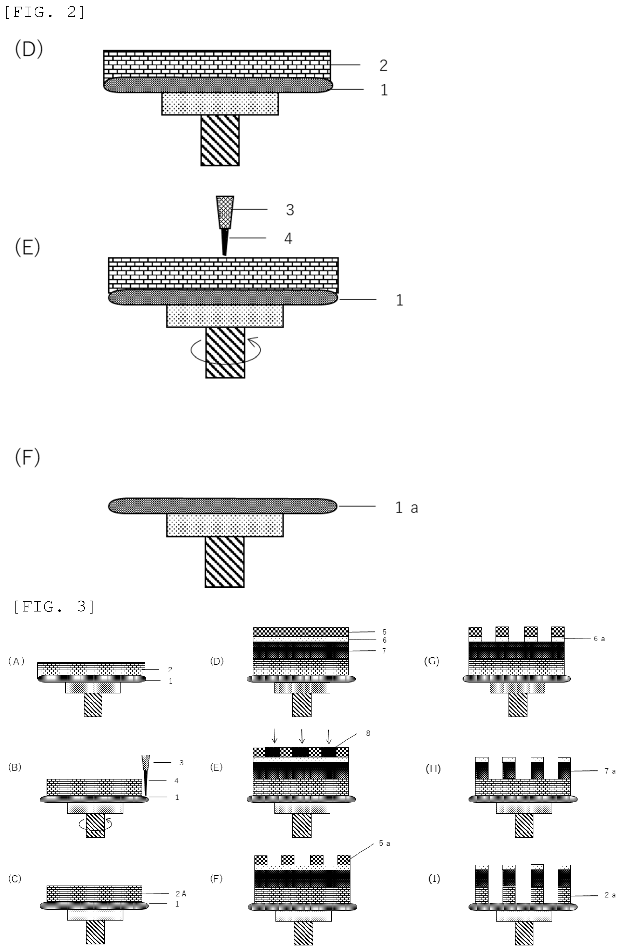

As a second embodiment of the present invention, a method for stripping a metal-containing film using the inventive cleaning solution will be described with reference to FIG. 2.

In a second embodiment (FIG. 2) of the present invention, (D) a substrate to be processed (1) on which a metal-containing film (2) has been formed is disposed in a spin coater. subsequently, (E) the spin coater is rotated at a predetermined rate; a cleaning solution discharge nozzle (3) travels to the center of the substrate to be processed (1); a cleaning solution (4) is discharged onto the rotating substrate (1) to be processed for a predetermined time; thereafter, the discharge of the cleaning solution (4) from the cleaning solution discharge nozzle (3) is stopped, and the substrate to be processed is dried as necessary. Thereby, a substrate to be processed, from which the metal-containing film has been stripped (1a), is obtained as shown in (F).

As a third embodiment of the present invention, a method for forming a metal-containing film pattern of the present invention will be described with reference to FIG. 3.

In a third embodiment of the present invention (FIG. 3), (A) a substrate to be processed (1), on which a metal-containing film (2) has been formed, is placed in a spin coater. Next, (B) the spin coater is rotated at a predetermined rate; the film at the outer periphery is removed while a cleaning solution (4) of the present invention is discharged from a cleaning solution discharge nozzle (3) positioned near the outer periphery; and then the substrate is dried as needed. (C) A metal-containing film, from which the film at the outer periphery has been removed (2A), is obtained. Next, (D) an organic resist underlayer film (7) is formed on the substrate to be processed; silicon-containing middle layer film (6) is formed thereon as a resist middle layer film; and an organic photoresist film is formed thereon as a resist upper layer film (5). Then, (E) exposure and development are performed to remove the unnecessary resist upper layer film (5b). And then, (F) a resist upper layer film (5a) with a pattern formed is obtained. Thereafter, (G) pattern transfer is performed by dry etching with a fluorine-based gas plasma to obtain a silicon-containing resist middle layer film on which a pattern is formed (6a). (H) Pattern transfer is performed by dry etching with an oxygen-based or hydrogen-based gas plasma to obtain an organic resist underlayer film with a pattern formed (7a). Subsequently, (I) a metal-containing film with a pattern formed (2a) is obtained.

### EXAMPLE

The present invention will be specifically explained below by showing synthesis examples, examples, and comparative examples, but the present invention is not limited thereto.

### <Synthesis of Polymer Compounds (B)>

### [Synthesis Examples of Polymer Compounds (B), (b-1) to (b-6)]

In the synthesis examples of the chelating agent (polymer compound) used in preparing the cleaning solution, the β-diketone group J: (J1) and (J2), and the compound group K: (K1) to (K5), shown below, were used. It should be understood that the diol used, represented by (K4), was a mixture with a number-average molecular weight of 300.

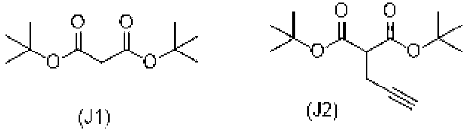

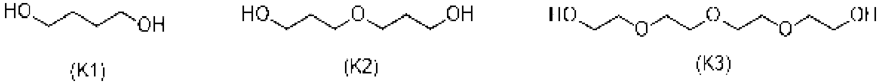

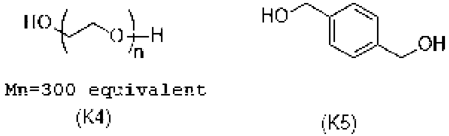

### [Synthesis Example 1] Synthesis of Chelating Agent Polymer Compound (b-1)

Under a nitrogen atmosphere, 30.0 g of β-diketone (J1), 11.9 g of Compound Group K (K1), and 50 g of o-xylene were added. The reaction was carried out for 2 hours at an internal temperature of 140°C while removing t-butyl alcohol produced by transesterification from the system. Subsequently, the temperature was raised to an internal temperature of 160°C while removing t-butyl alcohol and o-xylene from the system, and the reaction was carried out at this temperature for 6 hours. After cooling to an internal temperature of 50°C, 200 g of hexane was added to precipitate a gum-like polymer. The mixture was then cooled to room temperature as it is, and allowed to stand at room temperature for 1 hour, and then the supernatant was decanted. 300 g of PGMEA (propylene glycol monomethyl ether acetate) was added to the residue to form a homogeneous solution, and then water and low-boiling point solvent were distilled off. Furthermore, the concentration was adjusted to recover a 50% PGMEA solution of polymer compound (b-1) for a chelating agent.

The weight-average molecular weight (Mw) and dispersity (Mw/Mn) of the resulting polymer compound (b-1) were determined by GPC under the above-mentioned measurement conditions, and the results were as follows. (b-1): Mw = 11,500, Mw/Mn = 1.7

### [Synthesis Examples 2 - 6] Synthesis of Polymer Compounds (b-2) to (b-6)

Polymer compounds (b-2) to (b-6) shown in Table 1 were obtained under the same reaction conditions as in Synthesis Example 1, except that the β-diketone group J and the compound group K were used in the amounts shown in Table 1. The molecular weight and dispersity of the resulting polymer compounds are also shown.

**[Table 1]**

| Synthesis example | β-diketone group (J) | | Compound group (K) | | Polymer for chelating agent | | |
|---|---|---|---|---|---|---|---|
| | Material | g | Material | g | Compound | Mw | Mw/Mn |
| 1 | J1 | 30.0 | K1 | 11.9 | b-1 | 11500 | 1.7 |
| 2 | J1 | 30.0 | K2 | 17.7 | b-2 | 12500 | 1.8 |
| 3 | J1 | 30.0 | K3 | 25.6 | b-3 | 13800 | 1.7 |
| 4 | J1 | 30.0 | K4 | 52.7 | b-4 | 14600 | 2.2 |
| 5 | J2 | 30.0 | K3 | 21.8 | b-5 | 15300 | 2.0 |
| 6 | J1 | 30.0 | K5 | 18.2 | b-6 | 18200 | 1.6 |

### <Preparation of Cleaning Solution> (Examples 1-1 to 1-6, Comparative Examples 1-1 to 1-4)

Each cleaning solution was prepared by mixing the components in the proportions shown in Table 2.

The following compounds were used as comparative chelating agents (R-1) and (R-2):
(R-1): Acetylacetone
(R-2): Dimethyl malonate

As the solvent, propylene glycol methyl ethyl acetate (PGMEA) was used.

**[Table 2]**

| Cleaning solution | Solvent (C) | Polymer compound (B) | | Organic acid (A) | |
|---|---|---|---|---|---|
| | Type (parts by mass) | Structure | (parts by mass) | Type | (parts by mass) |
| MER-1 | PGMEA(69) | b-1 | (1) | Acetic acid | (30) |
| MER-2 | PGMEA(69) | b-2 | (1) | Citric acid | (30) |
| MER-3 | PGMEA(69) | b-3 | (1) | Acetic acid | (30) |
| MER-4 | PGMEA(69) | b-4 | (1) | formic acid | (30) |
| MER-5 | PGMEA(69) | b-5 | (1) | Acetic acid | (30) |
| MER-6 | PGMEA(69) | b-6 | (1) | Citric acid | (30) |
| Comparative Example MER-1 | PGMEA(69) | R-1 | (1) | Acetic acid | (30) |
| Comparative Example MER-2 | PGMEA(69) | R-2 | (1) | Acetic acid | (30) |
| Comparative Example MER-3 | PGMEA(69) | R-2 | (1) | Formic acid | (30) |
| Comparative Example MER-4 | PGMEA(70) | - | - | Acetic acid | (30) |

### <Preparation of Compositions for Forming Metal-Containing Film>

### [Synthesis Examples of Metal Compound]

In the following Synthesis Examples, the metal source "M" ((M1) to (M3)) and the compound group "H" ((H1) to (H3)) shown below were used.
(M1): Ti(OBu)₄: tetrabutyl orthotitanate (B0742 available from Tokyo Chemical Industry Co., Ltd.)
(M2): Hf(OBu)₄: hafnium(IV) n-butoxide (667943 available from Sigma-Aldrich Corp)
(M3): Zr(OBu)₄: zirconium(IV) tetrabutoxide (80 mass% solution in 1-butanol) (Z0016 available from Tokyo Chemical Industry Co., Ltd.)

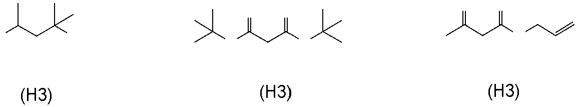

### [Synthesis Example 1] Synthesis of Metal Compound (m-1) for Forming Metal-Containing Film

Under a nitrogen atmosphere, into 40.5 g of a n-butanol solution of 28.4 g of tetrabutyl orthotitanate (M1), while stirring, 54.5 g of a n-butanol solution of 1.6 g of deionized water was added dropwise at room temperature over 2 hours. To the obtained solution, 9.9 g of the material group (H1) for the organic group was added, and the mixture was agitated at room temperature for 30 minutes. After the solution was concentrated under reduced pressure at 30°C, it was further heated to 60°C, and heating was continued under reduced pressure until no distillate was generated. When a distillate was no longer observed, 69.0 g of a PGMEA/PGME (ratio by weight: 70/30) solution was added thereto and heated under reduced pressure at 40°C until no isopropanol (IPA) was distilled. Thus, a PGMEA/PGME solution of a metal compound (m-1) for forming a metal-containing film was obtained. The concentration of the components in the solution other than the dissolving agent was 17% by mass.

### [Synthesis Examples 2 and 3] Synthesis of Compounds (m-2) and (m-3)

The compounds (m-2) and (m-3) shown in Table 3 were obtained under the same reaction conditions as in Synthesis Example 1, except that the metal source "M" and the compound group "H" were used at the charging amounts shown in Table 3.

**[Table 3]**

| Synthesis example | Metal material | | Compound group H | | Metal compound |
|---|---|---|---|---|---|
| | Material | g | Material | g | |
| 1 | M1 | 28.4 | H1 | 9.9 | m-1 |
| 2 | M2 | 54.9 | H2 | 25.2 | m-2 |
| 3 | M3 | 57.5 | H3 | 17.0 | m-3 |

### Preparation of Compound (m-4)

As a metal compound (m-4), tin(II) 2-ethylhexanoate (T3149 available from Tokyo Chemical Industry Co., Ltd.) was used.

### [Preparation of Composition (MUL-1) for Forming Metal-Containing Film]

The metal compound (m-1) for forming a metal-containing film was dissolved in a mixed dissolving agent of propylene glycol monomethyl ether acetate (PGMEA) and propylene glycol monomethyl ether (PGME) in the proportion shown in Table 4, and the solution was filtered through a 0.02-µm membrane filter to prepare a composition (MUL-1) for forming a metal-containing film.

### [Preparation of Compositions (MUL-2 to MUL-4) for Forming Metal-Containing Film]

Each chemical liquid was prepared in the same manner as MUL-1, except that the type and the contained amount of each component were as shown in Table 4.

**[Table 4]**

| Composition for forming a metal-containing film | Metal compound | | Solvent | |
|---|---|---|---|---|
| | Type | parts by mass | Type | parts by mass |
| MUL-1 | m-1 | 10.0 | PGMEA/PGME | 70/20 |
| MUL-2 | m-2 | 10.0 | PGMEA/PGME | 70/20 |
| MUL-3 | m-3 | 10.0 | PGMEA/PGME | 70/20 |
| MUL-4 | m-4 | 15.0 | PGEE | 65/20 |

### <Metal Detergency Evaluation>

The above-prepared metal-containing film-forming compositions (MUL-1 to MUL-4) were spin-coated onto 300 mm silicon substrates to obtain coatings. Measurements using an Atlax-XP ellipsometer revealed an average film thickness of 180 nm. 20 ml of cleaning solution (MER-1 to MER-6, comparative examples MER-1 to MER-4) was dispensed onto the resulting coatings, left for 30 seconds, then spin-dried and baked at 100°C for 60 seconds to evaporate the cleaning solution. The resulting silicon substrates were cut into 2.0 cm x 3.5 cm pieces to obtain evaluation substrate A. The resulting evaluation substrate A were then immersed in a 38% aqueous hydrofluoric acid solution for 1 minute to extract the metal components, yielding evaluation solution A. The obtained evaluation solution "A" was analyzed using a double-focusing high-resolution ICP-MS ELEMENT 2 manufactured by Thermo Fisher Scientific.

Solution "B" for evaluation was obtained by the same procedure as when obtaining the solution "A" for evaluation except that OK73 thinner was used instead of the cleaning solutions (MER-1 to MER-6, comparative Examples MER-1 to MER-4) and as the cleaning solution. OK73 thinner is a mixed dissolving agent of propylene glycol monomethyl ether and propylene glycol methyl ether acetate.

The metal detergency was evaluated as "Good" when the amount of metal, constituting the metal compound for forming a metal-containing film, detected from the solution "A" for evaluation was less than 30% relative to the solution "B" for evaluation, as "Fair" when 30% or more and less than 50%, and as "Poor" when 50% or more. The results are shown in Table 5.

**[Table 5]**

| Example | Composition for forming a metal-containing film | Cleaning solution | Analyzed metal | Amount of residual metal |
|---|---|---|---|---|
| Example 1-1 | MUL-1 | MER-1 | Ti | Good |
| Example 1-2 | MUL-2 | MER-2 | Zr | Good |
| Example 1-3 | MUL-3 | MER-3 | Hf | Good |
| Example 1-4 | MUL-4 | MER-4 | Sn | Good |
| Example 1-5 | MUL-2 | MER-5 | Zr | Good |
| Example 1-6 | MUL-2 | MER-6 | Zr | Good |
| Comparative Example 1-1 | MUL-2 | Comparative Example MER-1 | Zr | Fair |
| Comparative Example 1-2 | MUL-2 | Comparative Example MER-2 | Zr | Fair |
| Comparative Example 1-3 | MUL-2 | Comparative Example MER-3 | Zr | Fair |
| Comparative Example 1-4 | MUL-2 | Comparative Example MER-4 | Zr | Poor |

As shown in Table 5, Examples 1-1 to 1-6, which used the inventive cleaning solution, showed good results with small amounts of residual metal, demonstrating that the use of a polymer compound having a repeating unit structure having a β-diketone structure as a chelating agent improves metal detergency more efficiently than the addition of a monomolecular compound. On the other hand, Comparative Examples 1-1 to 1-4 showed large amounts of residual metal, demonstrating poor metal detergency.

### <Waste Compatibility> (Examples 2-1 to 2-6)

Mixed solutions were prepared by mixing each of the cleaning solutions (MER-1 to MER-6) prepared above with equal amounts of one of the compositions (MUL-1 to MUL-4) for forming a metal-containing film, a composition (SOC-1) for forming a resist underlayer film, a composition (SOG-1) for forming a silicon-containing film, and a photoresist composition (PR-1). After leaving them to stand at 23°C for one week, they were visually observed for the presence of a precipitate or clouding. The waste compatibility was evaluated as "Good" when no precipitation or clouding was observed after the prepared mixed solution was left to stand at 23°C for one week, and as "Poor" when precipitation or clouding was observed. The results are shown in Table 10.

As the composition (SOC-1) for forming a resist underlayer film, the composition (SOG-1) for forming a silicon-containing film, and the photoresist composition (PR-1), the following materials were used.

The composition (SOC-1) for forming a resist underlayer film was prepared by dissolving a polymer represented by the organic underlayer film polymer (SOP1) in an organic solvent containing 0.1 mass% of FC-4430 (manufactured by Sumitomo 3M Limited) in the proportion shown in Table 6; and filtering the solution through a filter made of a fluororesin and having a pore size of 0.2 µm.

**[Table 6]**

| | Polymer for organic underlayer film | Organic solvent |
|---|---|---|
| | (Parts by mass) | (Parts by mass) |
| SOC-1 | SOP1 (7) | PGMEA (93) |

The structural formula of the organic underlayer film polymer (SOP1) used for the present evaluations is shown in Table 7.

**[Table 7]**

| Compound or polymer | Mw | Mw/Mn |
|---|---|---|
| 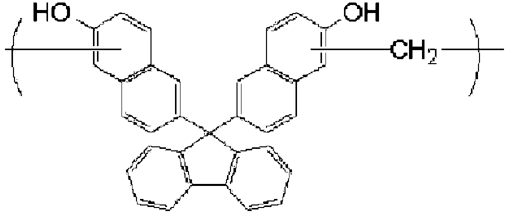 (SOP 1) | 3,700 | 2.82 |

The composition (SOG-1) for forming a silicon-containing film was prepared by dissolving a polymer represented by the silicon-containing middle layer film polymer (SiP1) and a crosslinking catalyst (CAT1) in an organic solvent containing 0.1 mass% of FC-4430 (manufactured by Sumitomo 3M Limited) in the proportion shown in Table 8; and filtering the solution through a filter made of a fluororesin and having a pore size of 0.1 µm.

**[Table 8]**

| | Polymer | Crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The structural formulae of the silicon-containing middle layer film polymer (SiP1) and the crosslinking catalyst (CAT1), which are used in the present evaluations, are shown below.

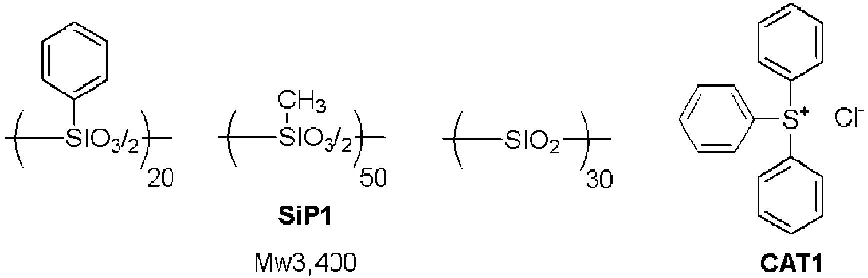

The photoresist composition (PR-1) was prepared by dissolving the polymer shown below, a quencher, and a sensitizer in an organic solvent containing 0.25 mass% of FC-4430 (manufactured by Sumitomo 3M Limited) in the proportion shown in Table 8; and filtering the solution through a filter made of a fluororesin and having a pore size of 0.1 µm.

### Polymer:

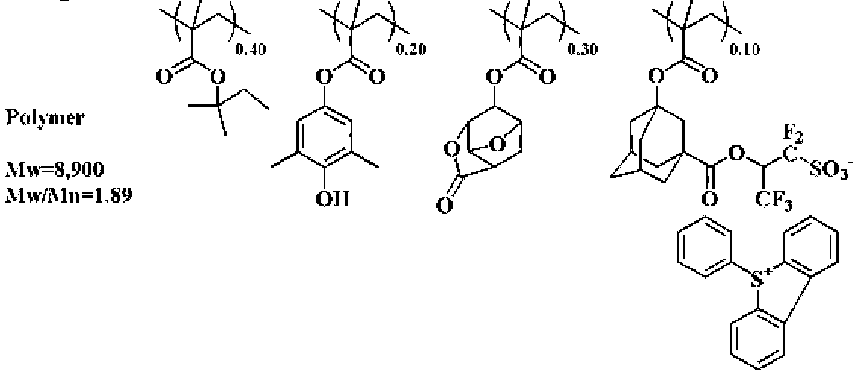

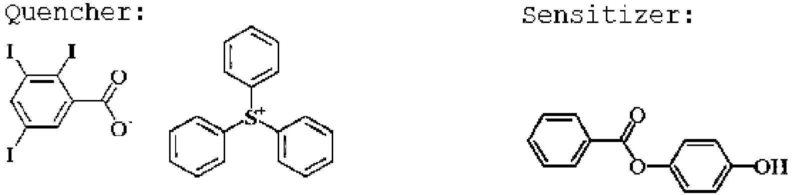

### Surfactant: FC-4430, manufactured by 3M Company

**[Table 9]**

| Component | Polymer | Quencher | Sensitizer | Surfactant | Organic solvent |
|---|---|---|---|---|---|
| PR-1 (parts by mass) | (100) | (4.0) | (2.1) | (0.25) | PGMEA (400) |
| | | | | | CyHO (2000) |
| | | | | | PGME (100) |

| | | | | | |
|---|---|---|---|---|---|
| •Organic solvent:PGMEA (propylene glycol monomethyl ether acetate) CyHO (Cyclohexanone) PGME (Propylene Glycol Monomethyl Ether) | | | | | |

**[Table 10]**

| Example | Cleaning solution | Composition for forming a metal-containing film | | Composition for forming a resist underlayer film | | Composition for forming a silicon-containing film | | Photoresist composition | |
|---|---|---|---|---|---|---|---|---|---|
| | | Material | storage stability | Material | storage stability | Material | storage stability | Material | storage stability |
| Example 2-1 | MER-1 | MUL-1 | Good | SOC-1 | Good | SOG-1 | Good | PR-1 | Good |
| Example 2-2 | MER-2 | MUL-2 | Good | SOC-1 | Good | SOG-1 | Good | PR-1 | Good |
| Example 2-3 | MER-3 | MUL-3 | Good | SOC-1 | Good | SOG-1 | Good | PR-1 | Good |
| Example 2-4 | MER-4 | MUL-4 | Good | SOC-1 | Good | SOG-1 | Good | PR-1 | Good |
| Example 2-5 | MER-5 | MUL-1 | Good | SOC-1 | Good | SOG-1 | Good | PR-1 | Good |
| Example 2-6 | MER-6 | MUL-2 | Good | SOC-1 | Good | SOG-1 | Good | PR-1 | Good |

As shown in the results in Table 10, in Examples (2-1 to 2-6) using the inventive cleaning solution, the addition of a polymer compound suppressed precipitation even when mixed with various film material compositions, demonstrating excellent waste compatibility.

As described above, the inventive cleaning solution contains a polymer compound having a repeating unit structure having a β-diketone structure. Thus, it is possible to provide a cleaning solution excellent in cleaning property, such as removal of a metal-containing film on the periphery of a substrate, and waste compatibility when a composition for forming a metal-containing film has been applied to the substrate. According to a method for cleaning a substrate by using the cleaning solution and a method for forming a metal-containing film by using the cleaning solution, a cleaning solution excellent in detergency and waste compatibility is used. Therefore, the desired resist underlayer film can be formed efficiently. These can be used suitably in the production of semiconductor devices and so forth, which are expected to be further miniaturized in the future.

The present description includes the following embodiments.
[1]: A cleaning solution for a composition for forming a metal-containing film, the cleaning solution comprising:
   (A) an organic acid;
   (B) a polymer compound having a repeating unit structure having a β-diketone structure; and
   (C) a solvent.
[2]: The cleaning solution of the above [1], wherein the repeating unit structure having a β-diketone structure is a structure represented by the following general formula (B-1), 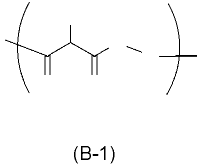
   wherein, R₁ represents a hydrogen atom, a substituted or unsubstituted alkyl group having 1 to 30 carbon atoms, a substituted or unsubstituted branched or cyclic alkyl group having 3 to 30 carbon atoms, a substituted or unsubstituted aliphatic unsaturated organic group having 2 to 30 carbon atoms and having one or more double or triple bonds, a substituted or unsubstituted alkoxy group having 1 to 30 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom; and X represents a divalent organic group represented by the following general formula (B-1a),

      *¹- - -*²
   wherein, W represents a divalent organic group, "*¹" represents an attachment point to an oxygen atom, and "*²" represents an attachment point to a carbonyl carbon atom of the β-diketone structure.
[3]: The cleaning solution of the above [2], wherein W in the general formula (B-1a) represents any one of a substituted or unsubstituted alkylene group having 1 to 30 carbon atoms, a substituted or unsubstituted branched or cyclic alkylene group having 3 to 30 carbon atoms, a substituted or unsubstituted divalent aliphatic unsaturated organic group having 2 to 30 carbon atoms and having one or more double or triple bonds, a substituted or unsubstituted heteroalkylene group having 1 to 30 carbon atoms, and a substituted or unsubstituted divalent aryl group having 6 to 30 carbon atoms.
[4]: The cleaning solution of the above [2], wherein X in the general formula (B-1) has a structure represented by the following formula (B-2a), 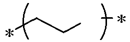 wherein m₁ represents the average number of repeating units, which represents 1 to 10, and "*" represents an attachment point.
[5]: The cleaning solution of the above [2], wherein the weight-average molecular weight Mw of the polymer having the repeating unit structure represented by the general formula (B-1) is in the range of 1,000≤Mw≤30,000, in terms of polystyrene, as determined by gel permeation chromatography.
[6]: The cleaning solution of any one of the above [1] to [5], wherein the solvent (c) comprises at least one dissolving agent selected from the group consisting of Ketone and ester dissolving agents.
[7]: The cleaning solution of any one of the above [1] to [6], wherein the organic acid (A) is a carboxylic acid.
[8]: The cleaning solution of any one of the above [1] to [7], wherein the polymer compound (B) is contained in an amount of 0.1 to 10 mass% relative to the total mass of the cleaning solution.
[9]: The cleaning solution of any one of the above [1] to [8], wherein the organic acid (A) is contained in an amount of 0.5 to 80 mass% relative to the total mass of the cleaning solution.
[10]: A method for cleaning a substrate comprising the steps of: applying a composition for forming a metal-containing film directly or indirectly to a substrate; and cleaning the substrate with the cleaning solution of any one of the above [1] to [9].
[11]: A method for forming a metal-containing film comprising the steps of: by using a composition for forming a metal-containing film comprising a metal compound (M) and a dissolving agent (D), applying the composition for forming a metal-containing film directly or indirectly to a substrate; and cleaning a peripheral edge of the substrate using the cleaning solution of any one of the above [1] to [9].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A cleaning solution for a composition for forming a metal-containing film, the cleaning solution comprising:
(A) an organic acid;
(B) a polymer compound having a repeating unit structure having a β-diketone structure; and
(C) a solvent.

2. The cleaning solution according to claim 1, wherein the repeating unit structure having a β-diketone structure is a structure represented by the following general formula (B-1), 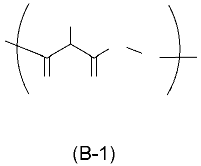
wherein, R₁ represents a hydrogen atom, a substituted or unsubstituted alkyl group having 1 to 30 carbon atoms, a substituted or unsubstituted branched or cyclic alkyl group having 3 to 30 carbon atoms, a substituted or unsubstituted aliphatic unsaturated organic group having 2 to 30 carbon atoms and having one or more double or triple bonds, a substituted or unsubstituted alkoxy group having 1 to 30 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom; and X represents a divalent organic group represented by the following general formula (B-1a),
*¹- - -*²
wherein, W represents a divalent organic group, "*¹" represents an attachment point to an oxygen atom, and "*²" represents an attachment point to a carbonyl carbon atom of the β-diketone structure.

3. The cleaning solution according to claim 2, wherein W in the general formula (B-1a) represents any one of a substituted or unsubstituted alkylene group having 1 to 30 carbon atoms, a substituted or unsubstituted branched or cyclic alkylene group having 3 to 30 carbon atoms, a substituted or unsubstituted divalent aliphatic unsaturated organic group having 2 to 30 carbon atoms and having one or more double or triple bonds, a substituted or unsubstituted heteroalkylene group having 1 to 30 carbon atoms, and a substituted or unsubstituted divalent aryl group having 6 to 30 carbon atoms.

4. The cleaning solution according to claim 2, wherein X in the general formula (B-1) has a structure represented by the following formula (B-2a), 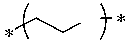 wherein m₁ represents the average number of repeating units, which represents 1 to 10, and "*" represents an attachment point.

5. The cleaning solution according to claim 2, wherein the weight-average molecular weight Mw of the polymer having the repeating unit structure represented by the general formula (B-1) is in the range of 1,000≤Mw≤30,000, in terms of polystyrene, as determined by gel permeation chromatography.

6. The cleaning solution according to any one of claims 1 to 5, wherein the solvent (c) comprises at least one dissolving agent selected from the group consisting of Ketone and ester dissolving agents.

7. The cleaning solution according to any one of claims 1 to 6, wherein the organic acid (A) is a carboxylic acid.

8. The cleaning solution according to any one of claims 1 to 7, wherein the polymer compound (B) is contained in an amount of 0.1 to 10 mass% relative to the total mass of the cleaning solution.

9. The cleaning solution according to any one of claims 1 to 8, wherein the organic acid (A) is contained in an amount of 0.5 to 80 mass% relative to the total mass of the cleaning solution.

10. A method for cleaning a substrate comprising the steps of: applying a composition for forming a metal-containing film directly or indirectly to a substrate; and cleaning the substrate with the cleaning solution according to any one of claims 1 to 9.

11. A method for forming a metal-containing film comprising the steps of: by using a composition for forming a metal-containing film comprising a metal compound (M) and a dissolving agent (D), applying the composition for forming a metal-containing film directly or indirectly to a substrate; and cleaning a peripheral edge of the substrate using the cleaning solution according to any one of claims 1 to 9.
